# EUROPÄISCHE PATENTSCHRIFT

(11) **EP 0 495 540 B1**
(45) Veröffentlichungstag und Bekanntmachung des Hinweises auf die Patenterteilung: **08.05.1996**
(21) Anmeldenummer: 92200010.4
(22) Anmeldetag: 03.01.1992
(51) Int. Cl.: H05K 3/46, H05K 1/00, H01P 3/08

(54) **Viellagenplatine, insbesondere für Hochfrequenz**
Multi-level board, especially for high frequency
Plaquette à circuits imprimés à plusieurs niveaux, notamment pour haute fréquence

(30) Priorität: 07.01.1991 DE 4100238
(43) Veröffentlichungstag der Anmeldung: 22.07.1992
(73) Patentinhaber: Philips Patentverwaltung GmbH, 22335 Hamburg (DE); Philips Electronics N.V., 5621 BA Eindhoven (NL)
(72) Erfinder: Kahlert, Joachim, Dr., W-5100 Aachen (DE); Noll, Joachim, Dr., W-5100 Aachen (DE); May, Klaus Peter, W-5100 Aachen (DE)
(74) Vertreter: Volmer, Georg, Dipl.-Ing.

(56) Entgegenhaltungen:
- EP-A- 0 137 694
- EP-A- 0 169 530

## Beschreibung

Die Erfindung betrifft eine Viellagenplatine, insbesondere für Hochfrequenz mit mindestens einer äußeren ersten planen dielektrischen Lage zur Aufnahme von Verbindungsbahnen gleichen Querschnitts und Komponenten sowie weiteren abwechselnd geschichteten metallischen und dielektrischen Lagen zur Bildung einer Bezugsmasse und über Durchkontaktierungen zur Spannungsversorgung der Verbindungsbahnen und Komponenten.

Als Verbindungstechnik zum Realisieren von komplexen Schaltungen werden gedruckte Schaltungen in Mehrfachlagentechnik verwendet, die als Viellagenplatinen bezeichnet werden. Bei steilen Signalflanken von beispielsweise digitalen Signalen, die von einer integrierten Schaltung zu einer anderen übertragen werden sollen, muß der Einfluß der Verbindungsbahnen berücksichtigt werden, wenn die Laufzeit in der Verbindungsbahn etwa in die Größenordnung der Anstiegszeit der Schaltung kommt. Schwerwiegende Impulsverformungen, Reflexionen und mehr oder weniger gedämpfte Schwingungen sind die Folge.

Diese Fehler können durch den Einsatz von Verbindungsbahnen mit definiertem Wellenwiderstand vermieden werden. Derartige Verbindungsbahnen werden Streifenleiter (Microstrip Line) genannt und lassen sich beispielsweise dadurch realisieren, daß man alle Verbindungsbahnen auf einer Seite einer dielektrischen Platte oder Lage herstellt und ggf. mit Komponenten bestückt und die gegenüberliegende Seite der dielektrischen Platte durchgehend metallisiert und elektrisch an Masse legt. Dadurch werden alle Verbindungsbahnen zu Streifenleitern.

Bei Hochfrequenzlösungen verwendet man deshalb spezielle Verbindungsbahn- und Platinen-Querschnittsgeometrien zur Herstellung von bestimmten Wellenwiderständen bzw. Verbindungsbahn-Impedanzen. Der charakteristische Wellenwiderstand bei einem beispielsweise rechteckigem Querschnitt einer Verbindungsbahn ergibt sich aus dessen Breite und Höhe sowie Dicke und Permittivität der Leiterplatte, also letztlich der Dielektrizitätskonstanten der dielektrischen Leiterplatte. Bei rundem Querschnitt der Verbindungsbahnen spielt neben der Permittivität im wesentlichen nur dessen Durchmesser eines Rolle, wenn jeweils die Dicke der dielektrischen Platte wesentlich größer als der Durchmesser oder die Höhe der Verbindungsbahnen ist. Dies ist beispielsweise aus den Lehrbüchern "Integrierte Mikrowellenschaltungen - Elektrische Grundlagen ..., R.K. Hoffmann, Springerverlag Berlin Heidelberg New York Tokyo 1983, Seite 142 ff." und "Impulse auf Leitungen, W. Hilberg, Oldenbourg Verlag München Wien, Seite 121 ff." bekannt.

Bei hochfrequenten Schaltungen besteht häufig das Problem, daß ein großer Teil der Schaltungen für einen bestimmten Wellenwiderstand ausgelegt ist, jedoch einige Schaltungsteile einen anderen, oft höheren Wellenwiderstand benötigen, bzw. das Verzweigungen analog zur Kompensation von Leistungsteilern in der Hochfrequenztechnik breitbandig und reflexionsarm anzupassen sind.

Werden Verbindungsbahnen mit rechteckigem Querschnitt verwendet, dann lassen sich die meisten Wellenwiderstandssprünge durch Anpassung der Querschnittsbreite bei gleicher Querschnittshöhe verwirklichen. Die normalerweise eingesetzten Ätztechniken bereiten hierbei keine Schwierigkeiten.

Problematisch ist jedoch die Anpassung der Wellenwiderstände bei Verwendung von gleichen beispielsweise runden Querschnitten für die Verbindungsbahnen. Entsprechende Viellagenplatinen, bei denen zum Herstellen der Verbindungsbahnen diskrete Drähte mit Hilfe sehr genauer Verlegemaschinen verlegt werden, sind unter der Bezeichnung Multiwire- und Microwire-Techniken beispielsweise aus "High Density Discrete Wiring Offers A Solution to Chip Carrier Design, C.L. Lassen, M.M. Motazedi, ELECTRONIC PACKAGING AND PRODUCTION, January 1983", "A Discrete-Wired Solution for High Speed Surface-Mounc Packaging, T.J. Buck, ELECTRONIC PACKAGING AND PRODUCTION, June 1985" und aus der Produktinformation "MICROWIRE™-Interconnection Technology, PCK Technology Division 322 South Service Road, Melville, N.Y. 11747" bekannt. Da bei derartigen Verlegetechniken die Drahtdurchmesser nicht veränderbar, sondern fest vorgegeben sind, lassen sich Wellenwiderstandsänderungen im Prinzip nur durch Veränderung der Dicke der dielektrischen Platten herstellen, da die Permittivität bei herkömmlichen Herstellungsmethoden in der Regel nicht variierbar ist.

Eine bekannte Methode zur Veränderung der Dicke der dielektrischen Platte ist ein gezieltes Abfräsen derselben im jeweils gewünschten Bereich. Dies hat jedoch eine uneben strukturierte Oberfläche zur Folge, die wiederum insbesondere das automatische Verlegen der Verbindungsbahnen erheblich erschwert und statt höherer Wellenwiderstände niedrigere in diesem Bereich zur Folge hat.

Weitere bekannte Möglichkeiten zur Anpassung der Wellenwiderstände sind schaltungstechnischer Natur. Sie beeinflussen nicht tatsächlich den Wellenwiderstand einer Verbindungsbahn, sondern kompensieren auf schaltungstechnischem Weg unerwünschte Fehler. Beispielsweise entstehen bei reproduzierbaren Ankopplungen an einen Hochgeschwindigkeitsbus immer Reflexionen. Zwar läßt sich der Bus am Ende reflexionsfrei abschließen, alle weiteren Koppelstellen werden jedoch Störstellen sein und somit Reflexionen verursachen. Eine Optimierung dieses Problems ist ein möglichst niederohmiger Abschluß der Busleitung, da die Koppelstellen die effektive Impedanz senken. Dies jedoch führt wieder zu Treiberproblemen, weshalb der Bus dann in einer vorgegebenen Impedanz betrieben wird und alle Koppelstellen hochohmig angekoppelt werden. Reflexionen am Busende müssen hierbei dann in Kauf genommen und aufgrund der Kenntnis ihrer Lage durch ein entsprechendes schaltungstechnisches Layout berücksichtigt werden. Schaltungstechnische Maßnahmen sind daher nur bedingt geeignet.

Der vorliegenden Erfindung liegt die Aufgabe zugrunde, eine Viellagenplatine, insbesondere für Hochfrequenz zu schaffen, die eine plane Fläche für Verbindungsbahnen und auf der Fläche vorbestimmte Bereiche hat, in denen Verbindungsbahnen mit gleichem Querschnitt unterschiedliche Wellenwiderstände haben.

Diese Aufgabe wird erfindungsgemäß gelöst durch die kennzeichnenden Merkmale des Anspruchs 1.

Erfindungsgemäß läßt sich die Veränderung der Wellenwiderstände bei vorgegebenem Querschnitt der Verbindungsbahnen und des Platinenquerschnitts durch eine Strukturierung von Spannungsversorgung und Masse auf derselben Ebene realisieren, indem die die dielektrischen Lagen trennenden metallischen Lagen in den gewünschten Bereichen eliminiert werden und in einer metallischen Lage eine metallische Insel isoliert ist, die mit der Bezugsmasse verbunden den in diesem Bereich gewünschten Streifenleiter erzeugt.

Bei maschineller Verlegung der Verbindungsbahnen können diese vorteilhaft einen gleichen und auch runden Querschnitt aufweisen.

Die Form der Fensterbereiche der Fenster in den metallischen Lagen und die dazu parallelen und mit diesen Fensterbereichen deckungsgleichen Inseln können beliebig den Erfordernissen des Platinenaufbaus, d.h. der Anordnung der Verbindungsbahnen auf der Platine angepaßt werden. Dies hat ferner den Vorteil, daß auch ein Platinenaufbau eingesetzt werden kann, der für eine Viellagenplatine mit überall gleichem Wellenwiderstand der Verbindungsbahnen ausgelegt ist. Die schaltungstechnischen Maßnahmen zur Vermeidung der Fehler können dann entfallen. Die Fensterbereiche werden vorteilhaft während der Herstellung der erfindungsgemäßen Viellagenplatine aus den entsprechenden metallischen Lagen herausgeätzt, ebenso wie ein schmaler Rand, der dann die jeweiligen Inseln bildet und begrenzt.

An sich bekannte Durchkontaktierungen, auch Via's genannt, können von den Verbindungsbahnen durch mindestens die erste und zweite dielektrische Lage und die erste metallische Lage hindurch zu mindestens einer von mehreren als Spannungsversorgung dienenden metallischen Lagen führen.

Vorteilhaft bildet für die Verbindungsbahnen die erste metallische Lage die Bezugsmasse. Deren elektrisches Potential kann über vergrabene Durchkontaktierungen an flächig ausgestalteten Kontaktstellen an den Inseln anliegen.

Vorteilhaft.eignet sich die erfindungsgemäße Viellagenplatine, wie auch bekannte Viellagenplatinen für eine zweiseitige Bestückung. Der Aufbau einer solchen Platine kann dann spiegelbildlich z.B. bezüglich einer als Spannungsversorgung dienenden metallischen Lage aufgebaut sein.

Vorteilhaft können die dielektrischen Lagen untereinander und die metallischen Lagen untereinander die gleiche Dicke aufweisen, um eine möglichst große Übereinstimmung zu bekannten Viellagenplatinen herzustellen und dadurch deren Austauschbarkeit zu vereinfachen.

Gemäß einer besonderen Ausgestaltung der Erfindung kann vorgesehen sein, daß die metallischen Lagen untereinander die gleiche Dicke aufweisen und die dielektrischen Lagen untereinander ungleich dick sind, um eine bessere, feinere Anpassung an einen gewünschten Wellenwiderstand zu ermöglichen.

Vorteilhaft kann ferner vorgesehen sein, daß bei einer zweiseitig bestückbaren Viellagenplatine die dielektrischen Lagen je Seite unterschiedlich dick sind.

Weitere vorteilhafte Ausgestaltungen der Erfindung ergeben sich aus den Unteransprüchen.

Ein Ausführungsbeispiel der Erfindung wird nachfolgend anhand einer Zeichnung mit mehreren Fig. erläutert. Es zeigt:
- Fig. 1: eine Draufsicht auf eine erfindungsgemäße Viellagenplatine,
- Fig. 2: eine Draufsicht auf auf eine Platine entsprechend Fig. 1 mit nicht dargestellten Ausbrüchen zur Sichtbarmachung der die Wellenwiderstände jeweils bildenden metallischen Lage bzw. Insel, und
- Fig. 3: eine geschnittene Seitenansicht einer erfindungsgemäßen Viellagenplatine.

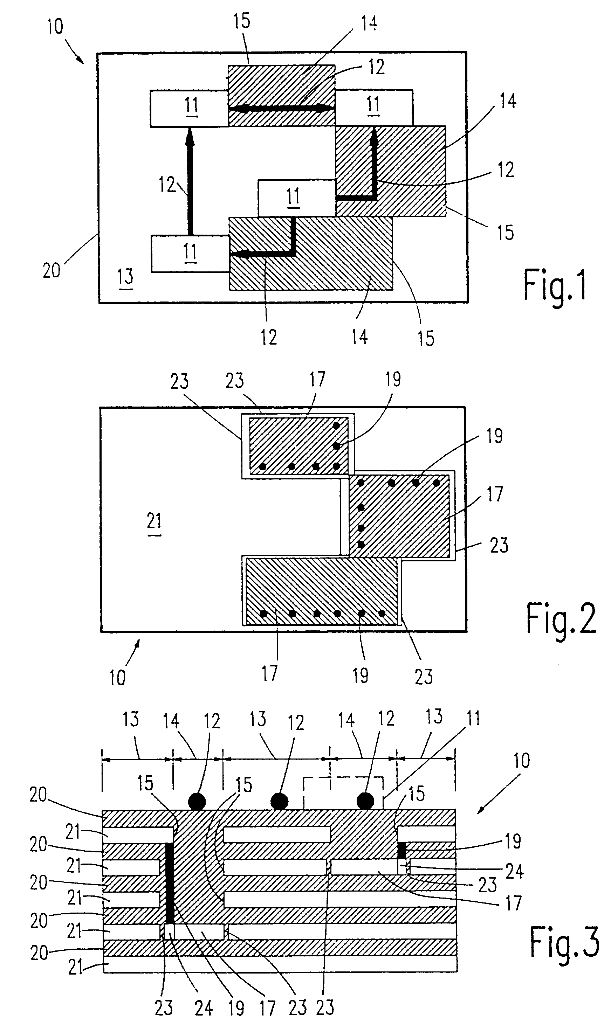

Fig. 1 zeigt eine Draufsicht auf eine erfindungsgemäße Viellagenplatine 10 mit schematisch dargestellten unterschiedlichen Komponenten 11. Die Komponenten 11 sind über die schematisch dargestellten Verbindungsbahnen 12 miteinander verbunden. Da die Komponenten 11 in der Regel unterschiedlich sind, werden in den Verbindungsbahnen 12 unterschiedliche Wellenwiderstände, meist gestaffelt höhere Leitungsimpedanzen benötigt. In einem Bereich 13, der in Fig. 1 nicht gestrichelt ist, kann die Viellagenplatine 10 in entsprechenden Verbindungsbahnen 12 einen Wellenwiderstand von beispielsweise 75 Ohm erzeugen. In Fensterbereichen 14 von Fenstern 15, die oben und mittig rechts in Fig. 1 schraffiert dargestellt sind, kann in den Verbindungsbahnen 12 ein Wellenwiderstand von beispielsweise 100 Ohm erzeugt werden. In dem in Fig. 1 unten schraffiert dargestellten Fensterbereich 14 des dortigen Fensters 15 kann in den Verbindungsbahnen 12 ein Wellenwiderstand von beispielsweise 125 Ohm erzeugt werden. Hier sei angemerkt, daß die Staffelung dieser Werte nur verdeutlichen soll, daß von einem niedrigen Wellenwiderstandswert, der grundsätzlich vorhanden ist, weitere Fenster 15 mit Fensterbereichen 14 auf derselben Platine 10 vorgesehen sein können, die höhere Wellenwiderstandswerte aufweisen.

In Fig. 2 ist ebenfalls eine Draufsicht auf eine erfindungsgemäße Viellagenplatine 10 gezeigt, bei der jedoch nicht dargestellte Ausbrüche vorhanden sind, so daß eine erste metallische Lage 21 im Bereich 13 entsprechend Fig. 1 sichtbar ist und ferner Inseln 17 in den oberen und mittleren Fensterbereichen 14 nach Fig. 1 sowie eine Insel 17 im unteren Fensterbereich 14 nach Fig. 1. In Fig. 2 sind in den Inseln 17 schematisch vergrabene Durchkontaktierungen 19 angedeutet, mit denen die Inseln 17 mit beispielsweise der ersten metallischen Lage 21 verbunden sind. Um die Inseln 17 ist teilweise ein Rand 23 sichtbar über den die Inseln 17 von der entsprechenden metallischen Lage 21 elektrisch getrennt sind.

Fig. 3 zeigt eine Seitenansicht einer erfindungsgemäßen Viellagenplatine 10. Hier wird darauf hingewiesen, daß die Anordnung der Fensterbereiche 14 in dieser Seitenansicht nicht der in Fig. 1 und 2 entspricht. Die Viellagenplatine 10 hat eine äußere, in Fig. 3 oben angeordnete erste plane dielektrische Lage 20 zur Aufnahme der Verbindungsbahnen 12 und der Komponenten 11, die oberhalb der Lage 20 durch kreisrunde Querschnittselemente und gestrichelt angedeutet sind. Die Verbindungsbahnen 12 haben kreisrunden gleichen Querschnitt und sind daher besonders gut zum automatischen Verlegen geeignet. Oberhalb der Lage 20 sind ebenfalls elektronische Komponenten 11 angeordnet. Unterhalb der Lage 20 schließt sich eine erste metallische Lage 21 und daran eine weitere dielektrische Lage 20 an. Die Viellagenplatine 10 weist weitere abwechselnd geschichtete dielektrische und metallische Lagen 20 und 21 auf.

Die erste metallische Lage 21 dient dabei elektrisch als Bezugsmasse und ist über vergrabene Durchkontaktierungen 19 mit den Inseln 17 verbunden. Die oberhalb der dielektrischen Lage 20 angeordneten in Fig. 3 gestrichelt dargestellten Komponenten 11 sind selbst oder über die Verbindungsbahnen 12 über nicht dargestellte Durchkontaktierungen mit einer der auf die erste metallische Lage 21 folgenden metallischen Lagen 21 verbunden, die als Spannungsversorgung dienen. Die erste metallische Lage 21 weist Fenster 15 mit Fensterbereichen 14 auf. Unterhalb des in Fig. 3 rechts angeordneten Fensterbereichs 14 der ersten Lage 21 weist die darauffolgende metallische Lage 21 eine Insel 17 auf, die durch einen Rand 23 von dieser metallischen Lage 21 isoliert ist. Unterhalb des in Fig. 3 links angeordneten Fensterbereichs 14 der ersten metallischen Lage 21 weisen zwei aufeinanderfolgende metallische Lagen 21 ebenfalls Fenster 15 und die darauffolgende Lage 21 eine Insel 17 auf, die ebenfalls über einen Rand 23 von dieser metallischen Lage 21 isoliert ist. Wie in Fig. 3 deutlich zu erkennen ist, weist der linke Fensterbereich 14 beispielsweise sieben dielektrische Lagen bis zur Insel 17 auf und der rechte Fensterbereich 14 drei Lagen bis zur Insel 17. Der übrige Bereich 13 weist dagegen nur eine dielektrische Lage 20 bis zur entsprechenden ersten metallischen Lage 21 auf, die die Bezugsmasse bildet. Hierdurch ist es auf einfache Weise möglich, unterschiedliche dielektrische Dicken und somit Wellenwiderstände bei gleichen Verbindungsbahnen 12 in vorbestimmten Bereichen z.B. 13 und 14 einer Viellagenplatine 10 vorzusehen.

Vorteilhaft kann dabei vorgesehen sein, daß die Fenster der Fensterbereiche 14 und die der dazu parallelen und deckungsgleichen Inseln 17 beliebig den Erfordernissen eines Platinenaufbaus angepaßt werden können.

Die Fensterbereiche 14 sind aus den metallischen Lagen 21 herausgeätzte Abschnitte. Zwischen einer metallischen Lage 21 und einer Insel 17 ist der die jeweilige Insel 17 bildende und begrenzende herausgeätzte schmale Rand 23 vorgesehen. .

Nicht dargestellte Durchkontaktierungen führen von den Verbindungsbahnen 12 und ggf. der Komponenten 11 durch mindestens die erste und die zweite dielektrische Lage 20 und erste metallische Lage 21 hindurch zu mindestens einer von mehreren als Spannungsversorgung dienenden metallischen Lagen 21.

Für die Verbindungsbahnen 12 bildet die erste metallische Lage 21 die Bezugsmasse. Über vergrabene Durchkontaktierungen 19 liegt das elektrische Potential der Bezugsmasse an den Inseln 17 an. Die sonst flächig den Fensterbereichen 14 entsprechenden Inseln 17 können hierzu Kontaktstellen 24 aufweisen, beispielsweise flächige Ausbuchtungen, wie in Fig. 3 angedeutet.

Die in Fig. 3 unterhalb der ersten metallischen Lage 21 angeordneten weiteren metallischen Lagen 21 dienen der Spannungsversorgung und können beim Aufbau einer zweiseitigen Bestückung als Spiegelebene dienen.

Wie in Fig. 3 dargestellt, können sowohl die dielektrischen Lagen 20 als auch die metallischen Lagen 21 untereinander jeweils die gleiche Dicke aufweisen. Hier sei angemerkt, daß die metallischen Lagen 21 sehr dünn z.B. aufgedampft sind. Zur genaueren und feineren Abstimmung kann vorgesehen sein, daß die metallischen Lagen 21 untereinander die gleiche Dicke aufweisen und die dielektrischen Lagen 20 untereinander unterschiedliche Dicken aufweisen. Ferner, daß bei zweiseitiger Bestückung die dielektrischen Lagen 20 auch je Seite unterschiedlich dick sind.

Da bei gleichen Dicken der dielektrischen Lagen 20 die Wellenwiderstände nur sprungweise variierbar sind und die Sprungweite von dieser Dicke abhängt, ist es für einen feiner einstellbaren und höheren Wellenwiderstand vorteilhaft, quasi die metallischen Lagen 21 selbst mehrfach aufzubauen, also sozusagen durch dünne Dielektrikumsschichten zu trennen, deren jeweilige Dicke wegen der erforderlichen Berechnung der Platine 10 dann exakt bekannt sein muß. Durch entsprechendes Ätzen von Fenstern 15 in mehreren solchen metallischen Lagen 21 und dem Kontaktieren einer abschließenden Insel 17 mit der Bezugsmasse läßt sich der Wellenwiderstand dann entsprechend der Anzahl der metallischen Lägen fein variieren, was besonders vorteilhaft ist, da dann für eine bestimmte Schaltung der bekannte Platinenaufbau nicht neu dimensioniert werden muß.

Die in der vorstehenden Beschreibung, in den Fig. 1, 2 und 3 sowie in den Ansprüchen 1 bis 10 offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Viellagenplatine, insbesondere für Hochfrequenz mit mindestens einer äußeren ersten planen dielektrischen Lage zur Aufnahme von Verbindungsbahnen gleichen Querschnitts und Komponenten sowie weiteren abwechselnd geschichteten metallischen und dielektrischen Lagen zur Bildung einer Bezugsmasse und über Durchkontaktierungen zur Spannungsversorgung der Verbindungsbahnen und Komponenten,
dadurch gekennzeichnet, daß mindestens die erste metallische Lage (21) mindestens ein Fenster (15) hat und die darauffolgende metallische Lage (21) eine dem Fensterbereich (14) des Fensters (15) entsprechende metallische Insel (17) aufweist, die über eine vergrabene Durchkontaktierung (19) mit der Bezugsmasse verbunden ist, und der Wellenwiderstand der Verbindungsbahnen (12) eine Funktion der resultierenden Dicke der wirksamen und im Fensterbereich (14) vermehrten dielektrischen Lagen (20) ist.

2. Platine nach Anspruch 1,
dadurch gekennzeichnet, daß die Fensterbereiche (14) aus einer metallischen Lage (21) herausgeätzte Abschnitte sind und zwischen einer metallischen Lage (21) und einer Insel (17) ein die Insel (17) bildender und begrenzender herausgeätzter schmaler Rand (23) vorhanden ist.

3. Platine nach Anspruch 2,
dadurch gekennzeichnet, daß Durchkontaktierungen von den Verbindungsbahnen (12) durch mindestens die erste und zweite dielektrische Lage (20) und erste metallische Lage (21) hindurch zu mindestens einer von mehreren als Spannungsversorgung dienenden metallischen Lagen (21) führt.

4. Platine nach Anspruch 3,
dadurch gekennzeichnet, daß für die Verbindungsbahnen (12) die erste metallische Lage (21) die Bezugsmasse bildet und deren elektrisches Potential über die vergrabenen Durchkontaktierungen (19) an Kontaktstellen (24) an den Inseln (17) anliegt.

5. Platine nach Anspruch 4,
dadurch gekennzeichnet, daß einer metallischen Lage (21), die als Spannungsversorgung dient, ein spiegelbildlicher Aufbau für eine zweiseitige Bestückung der Platine (10) folgt.

6. Platine nach einem oder mehreren der vorhergehenden Ansprüche,
dadurch gekennzeichnet, daß die dielektrischen Lagen (20) untereinander und die z.B. aufgedampften metallischen Lagen (21) untereinander die gleiche Dicke aufweisen.

7. Platine nach einem oder mehreren der vorhergehenden Ansprüche,
dadurch gekennzeichnet, daß die metallischen Lagen (21) untereinander die gleiche Dicke aufweisen und die dielektrischen Lagen (20) untereinander ungleiche Dicken aufweisen.

8. Platine nach Anspruch 9,
dadurch gekennzeichnet, daß bei zweiseitiger Bestückung die dielektrischen Lagen (20) je Seite unterschiedlich dick sind.

## Claims

1. A multilayer printed circuit board, in particular, for high-frequency operation, comprising at least a first, outer, plane dielectric layer for accommodating interconnection paths of equal cross-section and components as well as further alternately provided metallic and dielectric layers for forming a reference mass and for the voltage supply to said interconnection paths and components *via* plated-through holes, characterized in that at least the first metal layer (21) comprises at least one window (15) and the subsequent metal layer (21) has a metal island (17) corresponding to the area (14) of the window (15), which island is connected to the reference mass *via* a buried plated-through hole (19), and the characteristic impedance of the interconnection paths (12) is a function of the resulting thickness of the effective dielectric layers (20) the number of which is increased in the area (14) of the window.

2. A printed circuit board as claimed in Claim 1, characterized in that the window areas (14) are sections which are etched out of a metal layer (21), and in that a narrow, etched-out edge (23) which forms and bounds an island (17) is situated between a metal layer (21) and the island (17).

3. A printed circuit board as claimed in Claim 2, characterized in that plated-through holes lead from the interconnection paths (12) through at least the first and the second dielectric layers (20) and the first metal layer (21) to at least one of a number of voltage-supplying metal layers (21).

4. A printed circuit board as claimed in Claim 3, characterized in that the first metal layer (21) forms the reference mass for the interconnection paths (12), and that the electric potential of said layer is applied to contact areas (24) at the islands (17) *via* buried plated-through holes (19).

5. A printed circuit board as claimed in Claim 4, characterized in that a voltage-supplying metal layer (21) is provided with a micro-image construction so as to enable components to be mounted on both sides of the printed circuit board (10).

6. A printed circuit board as claimed in one or more of the preceding Claims, characterized in that all the dielectric layers (20) have the same thickness and all the metal layers (21), which are provided for example by vacuum evaporation, have the same thickness.

7. A printed circuit board as claimed in one or more of the preceding Claims, characterized in that all the metal layers (21) have the same thickness, whereas the dielectric layers (20) have different thicknesses.

8. A printed circuit board as claimed in Claim 9, characterized in that pc boards which are provided with components on both sides comprise dielectric layers (20) having different thicknesses on either side.

## Revendications

1. Plaquette à circuit imprimé multicouche, en particulier pour haute fréquence, comportant au moins une première couche diélectrique plane externe pour recevoir des pistes de liaison de même section transversale et des composants ainsi que d'autres couches métalliques et diélectriques appliquées en alternance pour former une masse de référence et, via des métallisations de trous, pour alimenter en tension les pistes de liaison et les composants, caractérisée en ce qu'au moins la première couche métallique (21) présente au moins une fenêtre (15) et la couche métallique (21) suivante, un îlot métallique (17) correspondant à la zone (14) de la fenêtre (15), ledit îlot étant connecté à la masse de référence via une métallisation de trou enterrée (19), et en ce que l'impédance caractéristique des pistes de liaison (12) est fonction de l'épaisseur résultante des couches diélectriques (20) effectives et majorées dans la zone de fenêtre (14).

2. Plaquette selon la revendication 1, caractérisée en ce que les zones de fenêtres (14) sont des sections découpées par gravure dans une couche métallique (21) et en ce qu'un bord (23) étroit obtenu par gravure, formant et délimitant l'îlot (17), est présent entre une couche métallique (21) et un îlot (17).

3. Plaquette selon la revendication 2, caractérisée en ce que des métallisations de trous conduisent des pistes de liaison à au moins l'une de plusieurs couches métalliques (21) servant à l'alimentation en tension, à travers au moins la première et la deuxième couches diélectriques (20) et la première couche métallique (21).

4. Plaquette selon la revendication 3, caractérisée en ce que la première couche métallique (21) forme la masse de référence pour les pistes de liaison (12) et son potentiel électrique s'applique aux îlots (17) via les métallisations de trous enterrées (19) à des points de contact (24).

5. Plaquette selon la revendication 4, caractérisée en ce qu'une couche métallique (21), qui sert à l'alimentation en tension, est suivie d'une structure à symétrie de miroir pour le montage de composants sur les deux faces de la plaquette (10).

6. Plaquette selon une ou plusieurs des revendications précédentes, caractérisée en ce que les couches diélectriques (20) présentent chacune la même épaisseur et les couches métalliques (21), appliquées par exemple par vaporisation, présentent chacune la même épaisseur.

7. Plaquette selon une ou plusieurs des revendications précédentes, caractérisée en ce que les couches métalliques (21) présentent chacune la même épaisseur et les couches diélectriques (20) présentent chacune une épaisseur différente.

8. Plaquette selon la revendication 9, caractérisée en ce que, dans le cadre d'un montage sur les deux faces, les couches diélectriques (20) ont une épaisseur différente sur chaque face.
